(19) Europäisches Patentamt
European Patent Office
Office européen des brevets

(11) **EP 4 400 484 A1**

(12) **EUROPEAN PATENT APPLICATION**

(43) Date of publication:
**17.07.2024 Bulletin 2024/29**

(21) Application number: **23216263.6**

(22) Date of filing: **13.12.2023**

(51) International Patent Classification (IPC):
**C03C 21/00** (2006.01)       **B24B 1/00** (2006.01)

(52) Cooperative Patent Classification (CPC):
**C03C 21/002; B24B 1/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.01.2023 KR 20230006289**

(71) Applicant: **Samsung Display Co., Ltd.
Yongin-si, Gyeonggi-do 17113 (KR)**

(72) Inventors:
• **Kim, Seung Ho
17113 Giheung-gu, Yongin-si (KR)**

• **SHIM, Gyu In
17113 Giheung-gu, Yongin-si (KR)**
• **KIM, Seung
17113 Giheung-gu, Yongin-si (KR)**
• **PARK, Cheol Min
17113 Giheung-gu, Yongin-si (KR)**
• **LEE, Jae Gil
17113 Giheung-gu, Yongin-si (KR)**
• **JANG, Jin Won
17113 Giheung-gu, Yongin-si (KR)**
• **JUNG, So Mi
17113 Giheung-gu, Yongin-si (KR)**

(74) Representative: **Dr. Weitzel & Partner
Patent- und Rechtsanwälte mbB
Friedenstrasse 10
89522 Heidenheim (DE)**

(54) **GLASS ARTICLE AND DISPLAY DEVICE INCLUDING THE SAME**

(57) A glass article has a thickness in a range of 20 $\mu$m to 100 $\mu$m and a third elastic energy index of 1.8 $MPa^2/m^{0.5}$ or greater, where the third elastic energy index is defined by Equation 2-3: Third elastic energy index ($E_{elas3}$) = $G_{IC} \times (1/B) \times E_{abs}$ (Equation 2-3), where $G_{IC}$ is a fracture energy index defined by Equation 1: Fracture energy index ($G_{IC}$) = $(K_{IC}^2 \times (1-v^2))/E$ (Equation 1), where Kic is fracture toughness, v is Poisson's ratio, and E is Young's modulus, B is brittleness (fracture toughness Kic/hardness $H_v$), and $E_{abs}$ is absorption energy defined by Equation A: Absorption energy ($E_{abs}$) = $\sigma^2 \times (1-v)/E$ (Equation A), where $\sigma$ is surface strength defined by Equation B: Surface strength ($\sigma$) = $(E \times \alpha \times \rho^2)/(1-v)$ (Equation B), where E is Young's modulus, $\alpha$ is a thermal expansion coefficient, $\rho$ is density, and v is Poisson's ratio.

**Description**

BACKGROUND

1. Field

The present invention relates to a glass article and a display device including the glass article.

2. Description of the Related Art

Glass articles are widely used in electronic devices including display devices, in building materials, and the like. For example, a glass article is applied to a substrate of a flat panel display device, such as a liquid crystal display (LCD), an organic light emitting display (OLED) or an electrophoretic display, or to a cover window for protecting the display device.

As portable electronic devices such as smart phones and tablet personal computers (PCs) increase, glass articles applied to the portable electronic devices are frequently exposed to external impacts. Therefore, it is desired to develop a glass article that is thin for portability and can withstand external impacts.

Recently, display devices that can be folded for user convenience have been researched. A desired glass article applied to a foldable display device may have a thin thickness to relieve bending stress when folded and at the same time may have sufficient strength to withstand external impacts.

SUMMARY

A strength of a thin glass article may be improved by changing the component ratio of a composition of the glass article and the conditions of a manufacturing process.

Embodiments of the invention provide a glass article having high impact resistance characteristics because indices defined as specific physical properties have values equal to or greater than a certain value, and a display device including the glass article.

However, aspects of the invention are not restricted to the one set forth herein. The invention is described by the features of the independent claims. The above and other aspects of the invention will become more apparent to one of ordinary skill in the art to which the invention pertains by referencing the detailed description of the invention given below.

According to an embodiment of the invention, a glass article has a thickness in a range of 20 $\mu$m to 100 $\mu$m and a third elastic energy index of 1.8 MPa$^2$/m$^{0.5}$ or greater, where the third elastic energy index is defined by Equation 2-3 below:

$$\text{Third elastic energy index } (E_{elas3}) = G_{IC} \times (1/B) \times E_{abs} \qquad (\text{Equation 2-3}).$$

In Equation 2-3, Gic is a fracture energy index defined by Equation 1 below:

$$\text{Fracture energy index } (G_{IC}) = (K_{IC}{}^2 \times (1-v^2))/E \qquad (\text{Equation 1}).$$

In Equation 1, Kic is fracture toughness, v is Poisson's ratio, and E is Young's modulus,

In Equation 2-3, B is brittleness (fracture toughness Kic/hardness $H_v$), and $E_{abs}$ is absorption energy defined by Equation A below:

$$\text{Absorption energy } (E_{abs}) = \sigma^2 \times (1-v)/E \qquad (\text{Equation A}).$$

In Equation A, $\sigma$ is surface strength defined by Equation B below:

$$\text{Surface strength } (\sigma) = (E \times \alpha \times \rho^2)/(1-v) \qquad (\text{Equation B}).$$

In Equation B, E is Young's modulus, $\alpha$ is a thermal expansion coefficient, $\rho$ is density, and v is Poisson's ratio.

According to an embodiment of the invention, a glass article has a thickness in a range of 20 $\mu$m to 100 $\mu$m and a third free volume index of $5 \times 10^{-14}$ MPa$^4$/(m$^{2.5} \times$K$^3$) or greater, where the third free volume index is defined by Equation 3-3 below:

$$\text{Third free volume index } (V_{t3}) = G_{IC} \times (1/B) \times E_{abs} \times \sigma \times (1/(T_g)^3) \quad \text{(Equation 3-3).}$$

In Equation 3-3, $T_g$ is a glass transition temperature, and Gic is a fracture energy index defined by Equation 1 below:

$$\text{Fracture energy index } (G_{IC}) = (K_{IC}^2 \times (1-v^2))/E \quad \text{(Equation 1).}$$

In Equation 1, Kic is fracture toughness, v is Poisson's ratio, and E is Young's modulus,

In Equation 3-3, B is brittleness (fracture toughness Kic/hardness $H_v$), and $E_{abs}$ is absorption energy defined by Equation A below:

$$\text{Absorption energy } (E_{abs}) = \sigma^2 \times (1-v)/E \quad \text{(Equation A).}$$

In Equation 3-3 and A, $\sigma$ is surface strength defined by Equation B below:

$$\text{Surface strength } (\sigma) = (E \times \alpha \times \rho^2)/(1-v) \quad \text{Equation (B).}$$

In Equations A and B, E is Young's modulus, $\alpha$ is a thermal expansion coefficient, $\rho$ is density, and v is Poisson's ratio.

According to an embodiment of the invention, a glass article has a thickness in a range of 20 $\mu$m to 100 $\mu$m and a second elastic energy index of $5.0 \times 10^{-5}$ (kJ/m$^2$)$^2$ or greater defined by Equation 2-2 below:

$$\text{Second elastic energy index } (E_{elas2}) = G_{IC} \times (1/B)^6 \times E_{abs} \quad \text{(Equation 2-2).}$$

In Equation 2-2, Gic is a fracture energy index defined by Equation 1 below:

$$\text{Fracture energy index } (G_{IC}) = (K_{IC}^2 \times (1-v^2))/E \quad \text{(Equation 1).}$$

In Equation 1, Kic is fracture toughness, v is Poisson's ratio, and E is Young's modulus,

In Equation 2-2, B is brittleness (fracture toughness Kic/hardness $H_v$), and $E_{abs}$ is absorption energy defined by Equation A below:

$$\text{Absorption energy } (E_{abs}) = \sigma^2 \times (1-v)/E \quad \text{(Equation A).}$$

In Equation A, $\sigma$ is surface strength defined by Equation B below:

$$\text{Surface strength } (\sigma) = (E \times \alpha \times \rho^2)/(1-v) \quad \text{(Equation B).}$$

In Equation A and B, E is Young's modulus, $\alpha$ is a thermal expansion coefficient, $\rho$ is density, and v is Poisson's ratio.

According to an embodiment of the invention, a glass article has a thickness in a range of 20 $\mu$m to 100 $\mu$m and a second free volume index of $5 \times 10^{-9}$ (kJ/m$^2$)$^2$/K or greater, where the second free volume index is defined by Equation 3-2 below:

$$\text{Second free volume index } (V_{t2}) = G_{IC} \times (1/B)^6 \times E_{abs} \times (1/T_g) \quad \text{(Equation 3-2),}$$

In Equation 3-2, $T_g$ is a glass transition temperature, and Gic is a fracture energy index defined by Equation 1

below:

$$\text{Fracture energy index } (G_{IC}) = (K_{IC}^2 \times (1\text{-}v^2))/E \qquad \text{(Equation 1)}.$$

In Equation 1, Kic is fracture toughness, v is Poisson's ratio, and E is Young's modulus,

In Equation 3-2, B is brittleness (fracture toughness Kic/hardness $H_v$), and $E_{abs}$ is absorption energy defined by Equation A below:

$$\text{Absorption energy } (E_{abs}) = \sigma^2 \times (1\text{-}v)/E \qquad \text{(Equation A)},$$

In Equation A, σ is surface strength defined by Equation B below:

$$\text{Surface strength } (\sigma) = (E \times \alpha \times \rho^2)/(1\text{-}v) \qquad \text{(Equation B)},$$

In Equations A and B, E is Young's modulus, α is a thermal expansion coefficient, ρ is density, and v is Poisson's ratio.

According to an embodiment of the invention, a display device includes a display panel comprising a plurality of pixels, a cover window disposed on the display panel, and an optically clear bonding layer disposed between the display panel and the cover window, where the cover window includes a glass article having a thickness in a range of 20 μm to 100 μm, a fracture energy index of 150 kJ/m² or greater, and a third elastic energy index of 1.8 MPa²/m^0.5 or greater, where the fracture energy index is defined by Equation 1 below, and the third elastic energy index is defined by Equation 2-3 below:

$$\text{Third elastic energy index } (E_{elas3}) = G_{IC} \times (1/B) \times E_{abs} \qquad \text{(Equation 2-3)}.$$

In Equation 2-3, Gic is the fracture energy index defined by Equation 1 below:

$$\text{Fracture energy index } (G_{IC}) = (K_{IC}^2 \times (1\text{-}v^2))/E \qquad \text{(Equation 1)}.$$

In Equation 1, Kic is fracture toughness, v is Poisson's ratio, and E is Young's modulus,

In Equation 2-3, B is brittleness (fracture toughness Kic/hardness $H_v$), and $E_{abs}$ is absorption energy defined by Equation A below:

$$\text{Absorption energy } (E_{abs}) = \sigma^2 \times (1\text{-}v)/E \qquad \text{(Equation A)}.$$

In Equation A, σ is surface strength defined by Equation B below:

$$\text{Surface strength } (\sigma) = (E \times \alpha \times \rho^2)/(1\text{-}v) \qquad \text{(Equation B)}.$$

In Equations A and B, E is Young's modulus, α is a thermal expansion coefficient, ρ is density, and v is Poisson's ratio.

According to an embodiment of the invention, a display device includes a display panel comprising a plurality of pixels, a cover window disposed on the display panel, and an optically clear bonding layer disposed between the display panel and the cover window, where the cover window comprises a glass article having a thickness in a range of about 20 μm to about 100 μm, a fracture energy index of 150 kJ/m² or greater, and a third free volume index of $5 \times 10^{-14}$ MPa⁴/(m^2.5 × K³) or greater, where the fracture energy index is defined by Equation 1 below, and the third free volume index is defined by Equation 3-3 below:

$$\text{Third free volume index } (V_{f3}) = G_{IC} \times (1/B) \times E_{abs} \times \sigma \times (1/(T_g)^3) \qquad \text{(Equation 3-3)}.$$

In Equation 3-3, $T_g$ is a glass transition temperature, and Gic is the fracture energy index defined by Equation 1 below:

$$\text{In Equation 3-3, Fracture energy index } (G_{IC}) = (K_{IC}^2 \times (1\text{-}v^2))/E \qquad \text{(Equation 1)}.$$

In Equation 1, Kic is fracture toughness, v is Poisson's ratio, and E is Young's modulus,
**[0041]** In Equation 3-3, B is brittleness (fracture toughness Kic/hardness $H_v$), and $E_{abs}$ is absorption energy defined by Equation A below:

$$\text{Absorption energy } (E_{abs}) = \sigma^2 \times (1\text{-}v)/E \qquad \text{(Equation A)}.$$

In Equations 3-3 and A, $\sigma$ is surface strength defined by Equation B below:

$$\text{Surface strength } (\sigma) = (E \times \alpha \times \rho^2)/(1\text{-}v) \qquad \text{(Equation B)}.$$

In Equations A and B, E is Young's modulus, $\alpha$ is a thermal expansion coefficient, $\rho$ is density, and v is Poisson's ratio.
According to an embodiment of the invention, a display device includes a display panel comprising a plurality of pixels, a cover window disposed on the display panel, and an optically clear bonding layer disposed between the display panel and the cover window, wherein the cover window comprises a glass article having a thickness of 20 to 100 $\mu$m, a fracture energy index of 150 kJ/m$^2$ or greater, and a second elastic energy index of $5.0 \times 10^{-5}$ (kJ/m$^2$)$^2$ or greater, where the fracture energy index is defined by Equation 1 below, and the second elastic energy index is defined by Equation 2-2 below:

$$\text{Second elastic energy index } (E_{elas2}) = G_{IC} \times (1/B)^6 \times E_{abs} \qquad \text{(Equation 2-2)}.$$

In Equation 2-2, Gic is the fracture energy index defined by Equation 1 below:

$$\text{Fracture energy index } (G_{IC}) = (K_{IC}^2 \times (1\text{-}v^2))/E \qquad \text{(Equation 1)}.$$

In Equation 1, Kic is fracture toughness, v is Poisson's ratio, and E is Young's modulus,
**[0047]** In Equation 2-2, B is brittleness (fracture toughness Kic/hardness $H_v$), and $E_{abs}$ is absorption energy defined by Equation A below:

$$\text{Absorption energy } (E_{abs}) = \sigma^2 \times (1\text{-}v)/E \qquad \text{(Equation A)}.$$

In Equation A, $\sigma$ is surface strength defined by Equation B below:

$$\text{Surface strength } (\sigma) = (E \times \alpha \times \rho^2)/(1\text{-}v) \qquad \text{(Equation B)}.$$

In Equations A and B, E is Young's modulus, $\alpha$ is a thermal expansion coefficient, $\rho$ is density, and v is Poisson's ratio.
According to an embodiment of the invention, a display device comprises a display panel comprising a plurality of pixels, a cover window disposed on the display panel, and an optically clear bonding layer disposed between the display panel and the cover window, wherein the cover window comprises a glass article having a thickness in a range of 20 $\mu$m to 100 $\mu$m, a fracture energy index of 150 kJ/m$^2$ or greater, and a second free volume index of $5 \times 10^{-8}$ (kJ/m$^2$)$^2$/K or greater, where the fracture energy index is defined by Equation 1 below, and the second free volume index is defined by Equation 3-2 below:

$$\text{Second free volume index } (V_{t2}) = G_{IC} \times (1/B)^6 \times E_{abs} \times (1/T_g) \qquad \text{(Equation 3-2)}.$$

In Equation 3-2, $T_g$ is a glass transition temperature, and Gic is the fracture energy index defined by Equation 1 below:

$$\text{Fracture energy index } (G_{IC}) = (K_{IC}^2 \times (1-v^2))/E \qquad \text{(Equation 1)}.$$

In Equation 1, Kic is fracture toughness, v is Poisson's ratio, and E is Young's modulus,

In Equation 3-2, B is brittleness (fracture toughness Kic/hardness $H_v$), and $E_{abs}$ is absorption energy defined by Equation A below:

$$\text{Absorption energy } (E_{abs}) = \sigma^2 \times (1-v)/E \qquad \text{(Equation A)}.$$

In Equation A, $\sigma$ is surface strength defined by Equation B below:

$$\text{Surface strength } (\sigma) = (E \times \alpha \times \rho^2)/(1-v) \qquad \text{(Equation B)}.$$

In Equations A and B, E is Young's modulus, $\alpha$ is a thermal expansion coefficient, $\rho$ is density, and v is Poisson's ratio.

BRIEF DESCRIPTION OF THE DRAWINGS

These and/or other feature of the invention will become apparent by describing in further detail embodiments thereof with reference to the accompanying drawings, in which:

FIG. 1 is a perspective view of glass articles according to various embodiments;
FIG. 2 is a perspective view illustrating a display device in an unfolded state, to which a glass article according to an embodiment is applied;
FIG. 3 is a perspective view illustrating the display device of FIG. 2 in a folded state;
FIG. 4 is a cross-sectional view illustrating an embodiment of a display device in which a glass article according to an embodiment is applied as a cover window thereof;
FIG. 5 is a cross-sectional view of a flat plate-shaped glass article according to an embodiment;
FIG. 6 is a graph illustrating a stress profile of the glass article according to the embodiment of FIG. 5;
FIG. 7 is a flowchart illustrating operations in a process of manufacturing a glass article according to an embodiment;
FIG. 8 is a schematic diagram illustrating a series of operations from a cutting operation to a post-tempering surface polishing operation of FIG. 7; and
FIG. 9 is a diagram illustrating a method of performing a pen drop test on a glass article according to an embodiment.

DETAILED DESCRIPTION

The invention will now be described more fully hereinafter with reference to the accompanying drawings, in which various embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present invention, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments will be described with reference to the accompanying drawings.

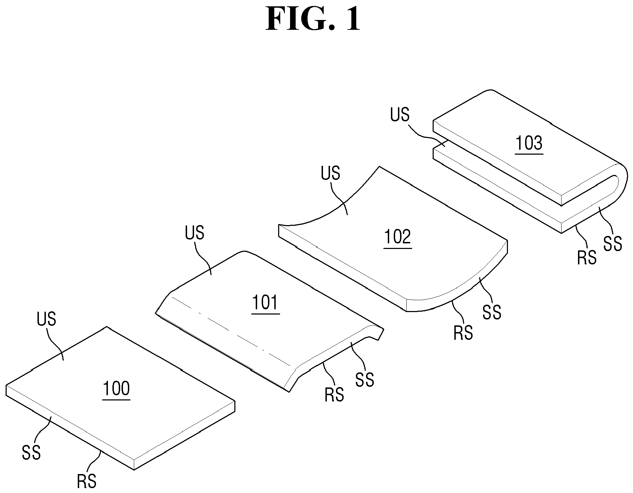

FIG. 1 is a perspective view of glass articles according to various embodiments.

Glass is used as a cover window for protecting a display, as a substrate for a display panel, as a substrate for a touch panel, as an optical member such as a light guide plate, and the like in electronic devices including displays such as tablet personal computers (PCs), notebook PCs, smartphones, electronic books, televisions and PC monitors as well as refrigerators and washing machines including display screens. The glass may also be used for cover glass of vehicle dashboards, cover glass of solar cells, building interior materials, and windows of buildings or houses.

Glass is desired to have great strength. In an embodiment, for example, glass for windows is desired to be thin to have high transmittance and light weight properties but also desired to be strong enough not to be easily broken by an external impact. Glass with increased strength may be produced using a method such as chemical tempering or thermal tempering. Embodiments of tempered glass having various shapes are illustrated in FIG. 1.

Referring to FIG. 1, in an embodiment, a glass article 100 may be in the shape of a flat sheet or a flat plate. In alternative embodiments, glass articles 101 through 103 may have a three-dimensional (3D) shape including a bent portion. In an embodiment, for example, a glass article may have edges of a flat portion bent (see ' 101'), may be generally curved (see '102'), or may be folded (see '103'). Alternatively, the glass article 100 may be shaped like a flat sheet or a flat plate but may have flexibility so that it can be folded, stretched, or rolled.

The glass articles 100 through 103 may have a rectangular planar shape. However, the glass articles 100 through 103 are not limited to the rectangular planar shape and may also have various planar shapes such as a rectangle with rounded corners, a square, a circle, and an oval. Hereinafter, for convenience of description, embodiments where the glass article 100 is a flat plate shape with a rectangular planar shape. However, it will be understood that the invention is not limited thereto.

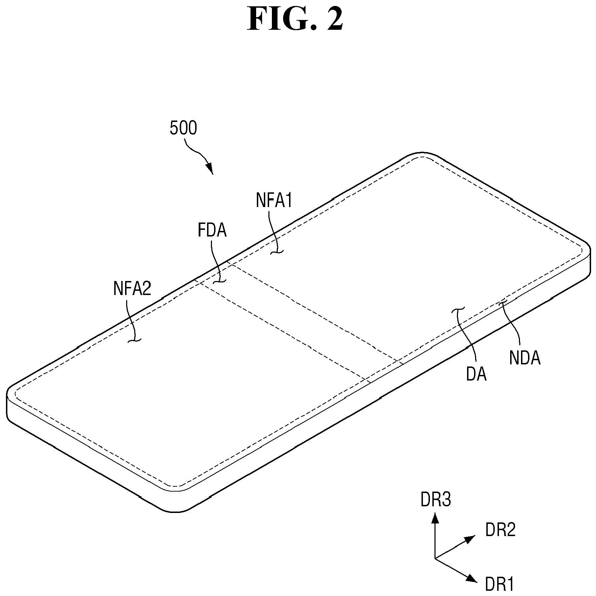

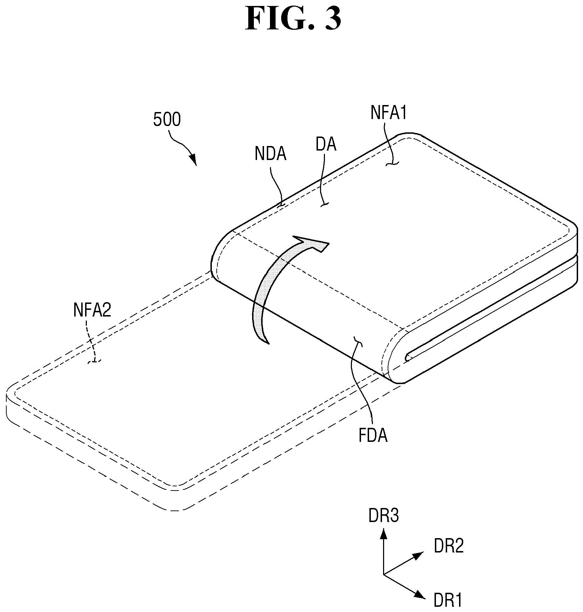

FIG. 2 is a perspective view illustrating a display device 500 in an unfolded state, to which a glass article according to an embodiment is applied. FIG. 3 is a perspective view illustrating the display device 500 of FIG. 2 in a folded state.

Referring to FIGS. 2 and 3, the display device 500 according to an embodiment may be a foldable display device. As will be described later, the glass article 100 of FIG. 1 may be applied to the display device 500 as a cover window. The glass article 100 may have flexibility to be folded or foldable.

In FIGS. 2 and 3, a first direction DR1 may be a direction parallel to a side of the display device 500 in a plan view (when viewed in a thickness direction of the display device 500), for example, a horizontal direction of the display device 500. A second direction DR2 may be a direction parallel to another side of the display device 500 in contact with the above side in a plan view, for example, a vertical direction of the display device 500. A third direction DR3 may be the thickness direction of the display device 500.

In an embodiment, the display device 500 may be rectangular in a plan view. The display device 500 may be shaped like a rectangle with perpendicular corners or a rectangle with rounded corners in a plan view. The display device 500 may include two short sides disposed in the first direction DR1 and two long sides disposed in the second direction DR2 in a plan view.

The display device 500 includes a display area DA and a non-display area NDA. The shape of the display area DA may correspond to the shape of the display device 500 in a plan view. In an embodiment, for example, where the display device 500 is rectangular in a plan view, the display area DA may also be rectangular.

The display area DA may include a plurality of pixels to display an image. The pixels may be arranged in a matrix form. Each of the pixels may be shaped like a rectangle, a rhombus, or a square in a plan view. However, the invention is not limited thereto. In an embodiment, for example, each of the pixels may also be shaped like a quadrilateral other than a rectangle, a rhombus or a square, a polygon other than a quadrilateral, a circle, or an oval in a plan view.

The non-display area NDA may not display an image because the non-display area NDA does not include pixels. The non-display area NDA may be disposed around the display area DA. The non-display area NDA may surround the display area DA. However, the invention is not limited thereto. The display area DA may also be partially surrounded by the non-display area NDA.

In an embodiment, the display device 500 may be maintained in one of both the folded state and the unfolded state. The display device 500 may be folded in an in-folding manner in which the display area DA is disposed inside as illustrated in FIG. 3. When the display device 500 is folded in the in-folding manner, portions of an upper surface of the display device 500 may face each other. Alternatively, the display device 500 may be folded in an out-folding manner in which the display area DA is disposed outside. When the display device 500 is folded in the out-folding manner, portions of a lower surface of the display device 500 may face each other.

In an embodiment, the display device 500 may be a foldable device. In the specification, the term "foldable device" is used to refer to devices that can be folded, including not only a folded device but also a device that can have both the folded state and the unfolded state. In addition, folding typically includes folding at an angle of about 180 degrees. However, the invention is not limited thereto, and folding at an angle of greater than or less than 180 degrees, such as folding at an angle of 90 to less than 180 degrees or an angle of 120 to less than 180 degrees may also be understood as folding. Furthermore, even an incompletely folded state may also be referred to as the folded state if it is not the unfolded state. For example, even a folded state at an angle of 90 degrees or less may be expressed as the folded state to be distinguished from the unfolded state as long as a maximum folding angle is 90 degrees or greater. The radius of curvature at the time of folding may be 5 millimeters (mm) or less, e.g., in a range of 1 mm to 2 mm or about 1.5 mm. However, the invention is not limited thereto.

In an embodiment, the display device 500 may include a folding area FDA, a first non-folding area NF A1, and a second non-folding area NFA2. The folding area FDA may be an area in which the display device 500 is folded, and the first non-folding area NFA1 and the second non-folding area NFA2 may be areas in which the display device 500 is not folded.

The first non-folding area NFA1 may be disposed on a side, e.g., an upper side of the folding area FDA. The second non-folding area NFA2 may be disposed on the other side, e.g., a lower side of the folding area FDA. The folding area FDA may be an area bent with a predetermined curvature.

In an embodiment, the folding area FDA of the display device 500 may be set at a specific position. In an embodiment of the display device 500, one folding area FDA or two or greater folding areas FDA may be set at a specific position. In an embodiment, the folding area FDA may not be limited to a specific position in the display device 500 but may be freely set or determined in various areas.

In an embodiment, the display device 500 may be folded in the second direction DR2. In such an embodiment, a length of the display device 500 in the second direction DR2 may be reduced to about half in the folded state. Therefore, a user can easily carry the display device 500.

In an embodiment, the direction in which the display device 500 is folded is not limited to the second direction DR2. In an embodiment, for example, the display device 500 may also be folded in the first direction DR1. In such an embodiment, the length of the display device 500 in the first direction DR1 may be reduced to about half in the folded state.

In the drawings, each of the display area DA and the non-display area NDA overlaps the folding area FDA, the first non-folding area NFA1, and the second non-folding area NFA2. However, the invention is not limited thereto. In an embodiment, for example, each of the display area DA and the non-display area NDA may overlap at least one of the folding area FDA, the first non-folding area NFA1, and the second non-folding area 0NFA2.

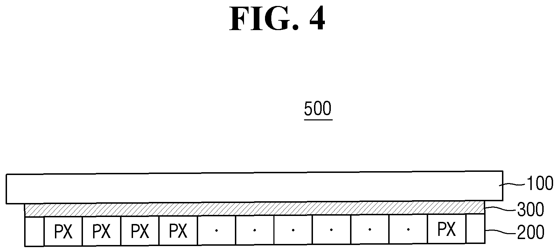

FIG. 4 is a cross-sectional view illustrating an embodiment of a display device 500 in which a glass article 100 according to an embodiment is applied as a cover window thereof.

Referring to FIG. 4, an embodiment of the display device 500 may include a display panel 200, the glass article 100 disposed on the display panel 200 and serving as a cover window, and an optically clear bonding layer 300 disposed between the display panel 200 and the glass article 100 to bond the display panel 200 and the glass article 100 together.

The display panel 200 may be, for example, a self-luminous display panel such as an organic light emitting display panel (OLED), an inorganic electroluminescent (EL) display panel, a quantum dot light emitting display panel (QED), a micro-light emitting diode (LED) display panel, a nano-LED display panel, a plasma display panel (PDP), a field emission display panel (FED) or a cathode ray tube (CRT) display panel or may be a light receiving display panel such as a liquid crystal display (LCD) panel or an electrophoretic display (EPD) panel.

The display panel 200 may include a plurality of pixels PX and may display an image using light emitted from each pixel PX. The display device 500 may further include a touch member (not illustrated). In an embodiment, the touch member may be internalized in the display panel 200. In an embodiment, for example, the touch member may be integrated in the display panel 200 or directly formed on a display member of the display panel 200 so that the display panel 200 itself can perform a touch function. In an alternative embodiment, the touch member may be manufactured separately from the display panel 200 and then attached to an upper surface of the display panel 200 by an optically clear bonding layer.

The glass article 100 is disposed on the display panel 200 to protect the display panel 200. The glass article 100 may be larger in size than the display panel 200. Thus, side surfaces of the glass article 100 may protrude further outward than side surfaces of the display panel 200, but the invention is not limited to this case. The display device 500 may further include a printed layer (not illustrated) disposed on at least one surface of the glass article 100 in an edge portion of the glass article 100. The printed layer may prevent a bezel area of the display device 500 from being visible from the outside and, in some cases, may perform a decorative function.

The optically clear bonding layer 300 is disposed between the display panel 200 and the glass article 100. The optically clear bonding layer 300 fixes the glass article 100 onto the display panel 200. The optically clear bonding layer 300 may include an optical clear adhesive (OCA) or an optical clear resin (OCR).

The tempered glass article 100 described above will now be described in greater detail.

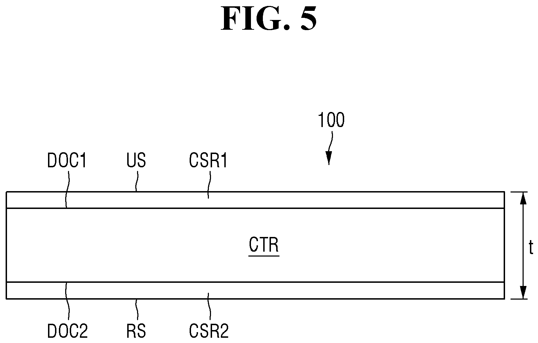

FIG. 5 is a cross-sectional view of a flat plate-shaped glass article 100 according to an embodiment.

Referring to FIG. 5, an embodiment of the glass article 100 may include a first surface US, a second surface RS, and side surfaces. The first surface US and the second surface RS of the flat plate-shaped glass article 100 are main surfaces having a large area, and the side surfaces are outer surfaces connecting the first surface US and the second surface RS.

The first surface US and the second surface RS are opposite to each other in the thickness direction. In a case where the glass article 100 serves to transmit light like a cover window of a display, the light may usually be incident on any one of the first surface US and the second surface RS and then transmitted to the other surface.

A thickness $t$ of the glass article 100 is defined as a distance between the first surface US and the second surface RS. The thickness $t$ of the glass article 100 may be, but is not limited to, 100 $\mu$m or less, e.g., in a range of 20 $\mu$m to 100 $\mu$m. In an embodiment, the thickness $t$ of the glass article 100 may be 80 $\mu$m or less. In an embodiment, the thickness $t$ of the glass article 100 may be about 75 $\mu$m or less. In an embodiment, the thickness $t$ of the glass article 100 may be about 70 $\mu$m or less. In an embodiment, the thickness $t$ of the glass article 100 may be about 60 $\mu$m or less. In an embodiment, the thickness $t$ of the glass article 100 may be about 65 $\mu$m or less. In an embodiment, the thickness $t$ of the glass article 100 may be about 50 $\mu$m or less. In an embodiment, the thickness $t$ of the glass article 100 may be about 30 $\mu$m or less. In some specific embodiments, the thickness $t$ of the glass article 100 may be in the range of 20 $\mu$m to 50 $\mu$m or may have a value of about 30 $\mu$m. The glass article 100 may have a uniform thickness $t$. However, the invention is not limited thereto, and the glass article 100 may also have a different thickness $t$ in each region.

The glass article 100 may be tempered to have a predetermined stress profile therein. The glass article 100 after being tempered better prevents crack generation, crack propagation, and breakage due to an external impact than the glass article 100 before being tempered. The glass article 100 tempered through a tempering process may have various stresses in different regions. In an embodiment, for example, compressive regions CSR1 and CSR2 in which compressive stress acts may be disposed near the surfaces of the glass article 100, that is, near the first surface US and the second surface RS, and a tensile region CTR in which tensile stress acts may be disposed inside the glass article 100. A stress value may be zero at boundaries DOC1 and DOC2 between the compressive regions CSR1 and CSR2 and the tensile region CTR. The compressive stress in one compressive region CSR1 or CSR2 may have a different stress value according to position (i.e., depth from the surface). In addition, the tensile region CTR may have a different stress value according to depth from the surface US or RS.

Positions of the compressive regions CSR1 and CSR2 in the glass article 100, stress profiles in the compressive regions CSR1 and CSR2, and compressive energies of the compressive regions CSR1 and CSR2 or tensile energy of the tensile region CTR may greatly affect mechanical properties (such as surface strength) of the glass article 100.

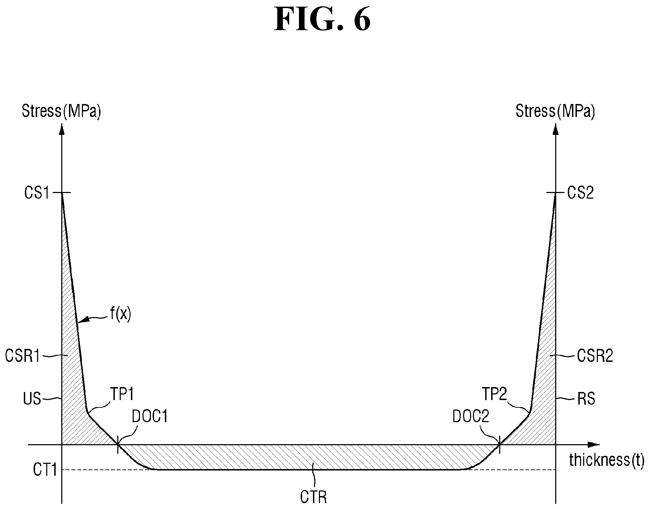

FIG. 6 is a graph illustrating a stress profile of the glass article 100 according to the embodiment of FIG. 5. In the graph of FIG. 6, the $x$ axis represents the thickness direction of the glass article 100. In FIG. 6, compressive stress is represented by a positive value, and tensile stress is represented by a negative value. In the specification, the magnitude of the compressive/tensile stress denotes the magnitude of an absolute value regardless of the sign of the value.

Referring to FIG. 6, the glass article 100 includes a first compressive region CSR1 extending (or expanding) from the first surface US to a first compression depth DOC1 and a second compressive region CSR2 extending (or expanding) from the second surface RS to a second compression depth DOC2. The tensile region CTR is disposed between the first compression depth DOC1 and the second compression depth DOC2. In the overall stress profile of the glass article 100, regions on both surface sides (US and RS) may be symmetrical to each other with respect to a center of the thickness (*t*) direction. Although not illustrated in FIG. 6, compressive regions and a tensile region may also be disposed between opposing side surfaces of the glass article 100 in a similar manner.

The first compressive region CSR1 and the second compressive region CSR2 resist external impacts to prevent generation of cracks in the glass article 100 or breakage of the glass article 100. The greater the maximum compressive stresses CS 1 and CS2 of the first and second compressive regions CSR1 and CSR2, the greater the strength of the glass article 100. Since an external impact is usually transmitted through the surfaces of the glass article 100, it is desired in terms of durability to have the maximum compressive stresses CS1 and CS2 at the surfaces of the glass article 100. In this regard, the compressive stresses of the first compressive regions CSR1 and the second compressive region CSR2 tend to be greatest at the surfaces and decrease toward the inside of the glass article 100.

The first compression depth DOC1 and the second compression depth DOC2 prevent cracks or grooves formed in the first and second surfaces US and RS from propagating to the tensile region CTR inside the glass article 100. The greater the first and second compression depths DOC1 and DOC2, the better the propagation of cracks can be prevented. Points corresponding to the first compression depth DOC1 and the second compression depth DOC2 correspond to the boundaries between the compressive regions CSR1 and CSR2 and the tensile region CTR and have a stress value of 0.

Throughout the glass article 100, the tensile stress of the tensile region CTR may be balanced with the compressive stresses of the compressive regions CSR1 and CSR2. That is, the sum of compressive stresses (i.e., compressive energies) in the glass article 100 may be equal to the sum of tensile stresses (i.e., tensile energies). In the glass article 100, the stress energy accumulated in one region having a certain width in the thickness (*t*) direction may be calculated by integrating a stress profile. When the stress profile in the glass article 100 having a thickness of *t* is represented by a function f(x), the following equation may be established.

$$\int_0^t f(x)dx = 0 \tag{1}.$$

As the magnitude of the tensile stress inside the glass article 100 increases, fragments may be violently expelled when the glass article 100 is broken, and crushing (or cracking) may occur from inside the glass article 100. The maximum tensile stress that meets the fragility criteria of the glass article 100 may satisfy, but not limited to, the following relation or inequality.

$$CT_1 \leq -38.7 \times \ln(t) + 48.2 \tag{2}.$$

In some embodiments, maximum tensile stress CT1 may be 100 Mpa or less or may be 85 MPa or less. A maximum tensile stress CT1 of 75 MPa or greater may improve mechanical properties such as strength. In an embodiment, the maximum tensile stress CT1 may be, but is not limited to, in a range of 75 MPa to 85 MPa.

The maximum tensile stress CT1 of the glass article 100 may be generally located in a central part of the glass article 100 in the thickness (*t*) direction. For example, the maximum tensile stress CT1 of the glass article 100 may be located at a depth in a range of 0.4 to 0.6 *t*, at a depth in a range of 0.45 to 0.55 *t*, or at a depth of about 0.5 *t*.

Large compressive stress and compressive depths DOC1 and DOC2 may be desired in increasing the strength of the glass article 100. However, as the compressive energy increases, the tensile energy may also increase, thereby increasing the maximum tensile stress CT1. In order for the glass article 100 to meet the fragility criteria while having high strength, the stress profile may be adjusted to increase the maximum compressive stresses CS1 and CS2 and the compression depths DOC1 and DOC2 and reduce the compressive energy. To this end, the glass article 100 may be manufactured using a glass composition including specific components in a predetermined ratio. Depending on the composition ratio of the components included in the glass composition, the manufactured glass article 100 may have high strength and, at the same time, may have flexible nature and physical properties to be effectively applicable to a foldable display device.

According to an embodiment, the glass composition that forms the glass article 100 may include $SiO_2$, $Al_2O_3$, $Na_2O$, $Li_2O$, CaO or MgO, and $ZrO_2$.

$SiO_2$ may form the framework of glass, increase chemical durability, and reduce generation of cracks when scratches (indentations) are formed on the glass surface. $SiO_2$ may be a network former oxide that forms a network of glass, and the glass article 100 manufactured to include $SiO_2$ may have a reduced coefficient of thermal expansion and improved mechanical strength.

$Al_2O_3$ improves crushability of glass. That is, $Al_2O_3$ may cause glass to be fragmented into a smaller number of pieces when the glass is broken. $Al_2O_3$ may be an intermediate oxide that forms a bond with $SiO_2$ forming a network structure. In addition, $Al_2O_3$ may act as an active component that improves ion exchange performance during chemical tempering and increases surface compressive stress after the tempering.

$Na_2O$ forms surface compressive stress through ion exchange and improves meltability of glass. $Na_2O$ may form non-bridging oxygen in a $SiO_2$ network structure by forming an ionic bond with oxygen of $SiO_2$ that forms the network structure. An increase in non-bridging oxygen may improve the flexibility of the network structure and may cause the glass article 100 to have physical properties to be applicable to a foldable display device.

Like $Na_2O$, $Li_2O$ forms surface compressive stress through ion exchange and improves meltability of glass. $Li_2O$ may form non-bridging oxygen in a $SiO_2$ network structure by forming an ionic bond with oxygen of $SiO_2$ that forms the network structure. An increase in non-bridging oxygen may improve the flexibility and shock absorption function of the network structure and may cause the glass article 100 to have physical properties to be applicable to a foldable display device.

MgO may improve the surface strength of glass and reduce the formation temperature of glass. MgO may be a network modifier oxide that modifies a $SiO_2$ network structure forming a network structure. MgO may reduce the refractive index of glass and adjust the thermal expansion coefficient and elastic modulus of glass. CaO may improve the surface strength of glass. CaO may be a network modifier oxide that modifies a $SiO_2$ network structure forming a network structure. CaO may increase the glass transition temperature of glass and improve the chemical durability of glass.

$ZrO_2$ may improve the transmittance and surface strength of glass and increase resistance to surface crack propagation. $ZrO_2$ may be an intermediate oxide that forms a bond with $SiO_2$ forming a network structure. $ZrO_2$ may be bonded to a part where bonds are broken by $Li_2O$ and $Na_2O$ in the $SiO_2$ network structure, thereby increasing the fracture toughness of glass and increasing the repulsive force against bending.

The glass composition may, if desired, include components such as $P_2O_5$, $B_2O_3$, $K_2O$, $SnO_2$, $Y_2O_3$, $La_2O_3$, $Nb_2O_5$, $Ta_2O_5$ and $Gd_2O_3$ in addition to the components listed above. In addition, the glass composition may further include trace amounts of $Sb_2O_3$, $CeO_2$, and/or $As_2O_3$ as a refining agent.

The glass article 100 manufactured using the glass composition according to an embodiment may have characteristics and physical properties to be applicable to a foldable display device. In an embodiment, for example, the glass article 100 may have flexibility so that it can be folded and unfolded and may have strength and chemical properties sufficient to be applicable as a cover window of the display device 500. In addition, the glass composition may provide flexibility to enable folding and unfolding of the glass article 100. The folding and unfolding characteristics of the glass article 100 may be improved by reducing the glass transition temperature and elastic modulus of glass. That is, as the elastic modulus of glass is reduced, the stress applied to a lower portion of the glass article during folding and unfolding is reduced. Accordingly, the bending characteristics of the glass article can be improved. In addition, impact resistance characteristics can be improved by lowering the modulus of elasticity that is inversely proportional to the probability of molecular vibration upon impact and by increasing a free volume fraction that is proportional to impact energy.

The glass composition having the above composition may be molded into the shape of plate glass using various methods known in the art. Once molded into the plate glass shape, the glass composition may be further processed to produce the glass article 100 that can be applied to the display device 500. However, the invention is not limited thereto, and the glass composition may also not be molded into the plate glass shape but may be directly molded into the glass article 100 applicable to a product without an additional molding process.

A process in which the glass composition is molded into the shape of plate glass, and then the glass is processed into the glass article 100 will now be described.

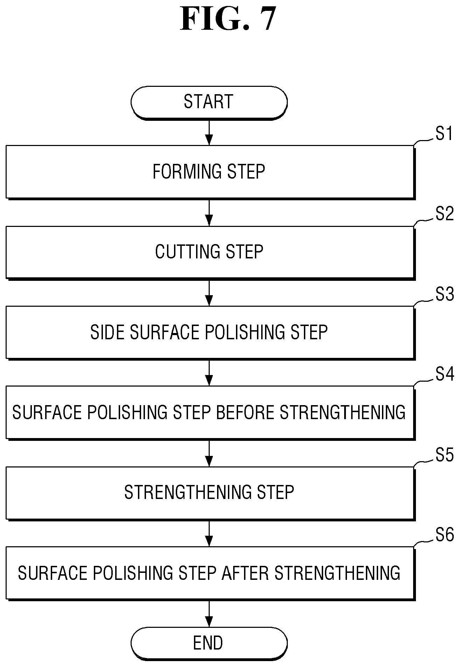

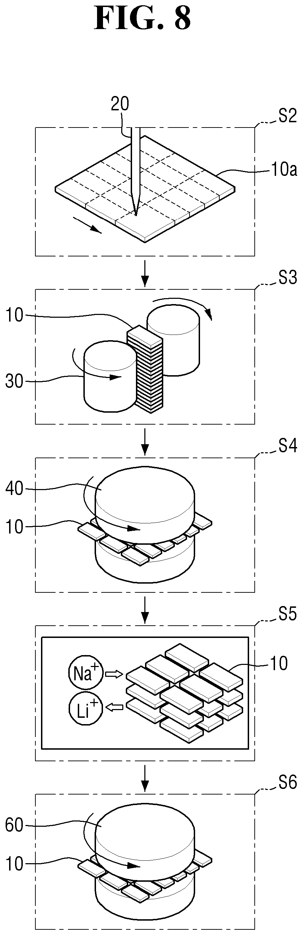

FIG. 7 is a flowchart illustrating operations in a process of manufacturing a glass article according to an embodiment. FIG. 8 is a schematic diagram illustrating a series of operations from a cutting operation to a post-tempering surface polishing operation of FIG. 7.

Referring to FIGS. 7 and 8, an embodiment of a method of manufacturing a glass article 100 may include a molding operation (operation S1), a cutting operation (operation S2), a side polishing operation (operation S3), a pre-tempering surface polishing operation (operation S4), a tempering operation (operation S5), and a post-tempering surface polishing operation (operation S6).

The molding operation (operation S1) may include preparing a glass composition and molding the glass composition. The glass composition may have the above-described composition and components, and any repetitive detailed description thereof will be omitted. The glass composition may be molded into a plate glass shape by a method such as a float process, a fusion draw process, or a slot draw process.

The glass molded into the flat plate shape may be cut through the cutting operation (operation S2). The glass molded into the flat plate shape may have a size different from the size applied to a final glass article 100. In an embodiment, for example, the glass 10a may be molded in the state of a large-area substrate as a mother substrate including a plurality of glass articles and then may be cut into a plurality of cells 10 to produce a plurality of glass articles. In an embodiment, for example, although the final glass article 100 has a size of about 6 inches, the glass may be molded to a size (e.g., 120 inches) several to hundreds of times the size of the final glass article 100 and then may be cut to produce 20 flat plate shapes at once. This can improve process efficiency as compared with when individual glass articles are molded separately. In addition, even when glass corresponding to the size of one glass article is molded, if a final glass article has various planar shapes, a desired shape may be formed through the cutting process.

The cutting of the glass 10a may be performed using a cutting knife 20, a cutting wheel, a laser, or the like.

The glass cutting operation (operation S2) may be performed before the glass tempering operation (operation S5). It is also possible to temper the glass 10a corresponding to a mother substrate and then cut the tempered glass 10a into final glass article sizes. In this case, however, cut surfaces (e.g., side surfaces) of the glass 10a may not be tempered. Therefore, it is desirable to perform the tempering operation (operation S5) after completing the cutting operation (operation S2).

A pre-tempering polishing operation may be performed between the glass cutting operation (operation S2) and the glass tempering operation (operation S5). The polishing operation may include the side polishing operation (operation S3) and the pre-tempering surface polishing operation (operation S4). In an embodiment, the side polishing operation (operation S3) may be performed before the pre-tempering surface polishing operation (operation S4), but this order can be reversed.

The side polishing operation (operation S3) is an operation of polishing side surfaces of the glass cells 10 into which the glass 10a has been cut. In the side polishing operation (operation S3), the side surfaces of the glass cells 10 may be polished to become smooth. In addition, the side surfaces of the glass cells 10 may become even through the side polishing operation (operation S3). More specifically, each glass cell 10 may include one or greater cut surfaces. Some of the glass cells 10 may have two cut surfaces out of four side surfaces. Some other glass cells 10 may have three cut surfaces out of four side surfaces. Some other glass cells 10 may have all four side surfaces as cut surfaces. Surface roughness may be different between a cut side surface and an uncut side surface. The surface roughness may also be different even between cut surfaces. Therefore, each side surface may be polished through the side polishing operation (operation S3) to have a uniform surface roughness. Furthermore, in a case where a small crack occurs in a side surface, it may also be removed through the side polishing operation (operation S3).

The side polishing operation (operation S3) may be simultaneously performed on the glass cells 10. That is, the glass cells 10 may be stacked and then simultaneously polished.

The side polishing operation (operation S3) may be performed by a mechanical polishing method or a chemical mechanical polishing method using a polishing device 30. In an embodiment, opposing facing side surfaces of each glass cell 10 may be simultaneously polished, and then the other two opposing side surfaces may be simultaneously polished. However, the invention is not limited thereto.

The pre-tempering surface polishing operation (operation S4) may be performed to ensure that each glass cell 10 has an even surface. The pre-tempering surface polishing operation (operation S4) may be performed on the glass cells 10 one by one. However, if a chemical mechanical polishing device 40 is sufficiently larger than the glass cells 10, the glass cells 10 may be arranged horizontally and then may be simultaneously surface-polished.

The pre-tempering surface polishing operation (operation S4) may be performed by a chemical mechanical polishing method. In an embodiment, a first surface and a second surface of each glass cell 10 are polished using a chemical mechanical polishing device 40 and polishing slurry. The first surface and the second surface may be polished simultaneously, or one surface may be polished first, and then the other surface may be polished.

The tempering operation (operation S5) is performed after the pre-tempering polishing operation (operation S4). The tempering operation (operation S5) may be performed as chemical tempering and/or thermal tempering. In the case of a glass cell 10 having a thin thickness of 2 mm or less, by extension, about 0.75 mm or less, a chemical tempering method may be suitably applied for precise stress profile control.

After the tempering operation (operation S5), the post-tempering surface polishing operation (operation S6) may be further performed optionally. The post-tempering surface polishing operation (operation S6) may serve to remove fine cracks in the surfaces of the tempered glass cells 10 and to control the compressive stress of the first and second surfaces of the tempered glass cells 10. In an embodiment, for example, in a floating method which is one of the plate glass manufacturing methods, a glass composition is poured into a tin bath. In this case, a surface in contact with the tin bath and a surface not in contact with the tin bath may have different compositions. Accordingly, a difference in compressive stress between the surface in contact with the tin bath and the surface not in contact with the tin bath may occur after the tempering of the glass cells 10 (operation S5). The difference in compressive stress between the surface in contact with the tin bath and the surface not in contact with the tin bath can be reduced by removing the surface of each glass cell 10 to an appropriate thickness through polishing.

The post-tempering surface polishing process (operation S6) may be performed using a chemical mechanical polishing method. Specifically, the first and second surfaces of the tempered glass cells 10 to be processed are polished using a chemical mechanical polishing device 60 and polishing slurry. A polishing thickness may be adjusted in a range of, but not limited to, 100 nm to 1000 nm. Polishing thicknesses of the first surface and the second surface may be the same as each other or different from each other.

Although not illustrated in the drawings, a shape machining process may be further performed as needed after the post-tempering surface polishing process (operation S6). In an embodiment, for example, when the 3D glass articles 101 through 103 illustrated in FIG. 1 are to be manufactured, a 3D machining process may be performed after the post-tempering surface polishing process (operation S6) is completed.

As described above, the glass article 100 manufactured through the above process may be applied as a cover window of the display device 500 which is a foldable display device. The glass article 100 may have flexibility and foldability. In addition, the glass article 100 may have impact resistance characteristics sufficient to be applicable as a cover window.

The impact resistance characteristics of the glass article 100 may be related to various mechanical and chemical properties of the glass article 100. For example, the glass article 100 may have properties such as coefficient of thermal expansion, transition temperature, density, Young's modulus, Poisson's ratio, Vickers hardness, fracture toughness, and brittleness. The above properties are measurable through a specimen of the glass article 100. Generally, when values of the above properties are above a certain level, it can be said that the glass article 100 has high impact resistance characteristics. However, the numerical values used as criteria may be unclear. For example, when the above physical properties of various glass articles 100 are compared, it may be difficult to predict that a glass article 100 having a relatively high value in specific physical properties will necessarily have better resistance to external impacts than other glass articles 100. That is, whether the impact resistance characteristics of the glass article 100 are high is desired to be determined by comprehensively evaluating the glass article 100 for various physical properties, and it is impossible to evaluate the impact resistance characteristics of the glass article 100 using only the measurable properties of the glass article 100. In particular, when the glass article 100 is applied as a cover window of the display device 500, it may be unclear what level of impact resistance the glass article 100 has when the physical properties of the glass article 100 have what numerical values.

As one of the indicators for evaluating the impact resistance characteristics of the glass article 100, a pen drop test is used. According to a pen drop test performed by preparing certain specimens of various glass articles 100, the higher the pen height at which a glass article specimen starts to crack or break, the better the impact resistance characteristics of the glass article 100. That is, the results of the pen drop test may serve as clear criteria for evaluating the impact resistance characteristics rather than the numerical values of the physical properties of the glass article 100.

The breakage of the glass article 100 may be affected by upper damage and lower damage in an area to an impact has been applied and structural changes of molecules that form the glass article 100. If the glass article 100 has high resistance to the upper damage and the lower damage, it will easily withstand external impacts. If there is a free space between the molecules that form the glass article 100, it may be easy to change the structures of the molecules. Therefore, the glass article 100 will easily withstand external impacts.

Here, the breakage resistance and molecular structure of the glass article 100 may have the fracture energy and elastic energy of the glass article 100 and a free volume derived from the fracture energy and the elastic energy as major factors. Each of the facture energy and the elastic energy may have the above-described physical properties of the glass article 100 as major factors, and the free volume may have the fracture energy and the elastic energy as major factors. In the glass article 100, factors related to the fracture energy, the elastic energy and the free volume derived from the above-described physical properties may be defined.

According to an embodiment, the glass article 100 may have factors that are derived as measurable physical properties and are quantifiable, and the quantified factors may have high consistency with pen drop test results which are clear criteria for impact resistance characteristics. Therefore, the pen drop test results and the impact resistance characteristics of the glass article 100 can be predicted through values of specific factors, and the impact resistance characteristics of the glass article 100 can be improved by improving the values of the factors. The glass article 100 may have high pen drop characteristics, that is, impact resistance characteristics because the specific factors to be described later have values equal to or greater than a certain value. Hereinafter, various factors that can be derived from the measurable physical properties of the glass article 100 and that are highly consistent with the pen drop test results will be described.

The glass article 100 may have a fracture energy index defined as a major factor in bonding strength or resistance to upper damage against external impact. The fracture energy index may be defined by Equation 1 below.

$$\text{Fracture energy index } (G_{IC}) = (K_{IC}^2 \times (1-v^2))/E \ (kJ/m^2), \qquad \text{(Equation 1)}$$

where Kic is fracture toughness, v is Poisson's ratio, and E is Young's modulus. The unit of the fracture energy index Gic in Equation 1 may be kJ/m$^2$. Kic, v, and E may be substituted with values converted according to kJ/m$^2$ which is a unit of the fracture energy index Gic.

The fracture energy index may be defined as a factor related to the resistance of the glass article 100 to upper dent damage against external impact. The fracture energy index may have a higher value as the fracture toughness increases and as Poisson's ratio and Young's modulus decrease. In other words, the glass article 100 may have a higher fracture energy index value and greater bonding strength and resistance to upper damage against external impact as the fracture toughness increases and as Poisson's ratio and Young's modulus decrease. In an embodiment, for example, the fracture energy index of the glass article 100 defined by Equation 1 above may be 150 kJ/m$^2$ or greater.

According to an embodiment, the glass article 100 may have a first elastic energy index defined by Equation 2-1 below.

$$\text{First elastic energy index } (E_{elas1}) = (1/B) \times E_{abs} \text{ (MPa/m}^{1.5}), \qquad \text{(Equation 2-1)}$$

where B is brittleness (fracture toughness Kic/hardness H$_v$ (m$^{0.5}$)), and E$_{abs}$ is absorption energy. The unit of the first elastic energy index in Equation 2-1 may be MPa/m$^{1.5}$. In the above equation, B and E$_{abs}$ may be substituted with values converted according to MPa/m$^{1.5}$ which is a unit of the first elastic energy index E$_{elas1}$.

In Equation 2-1, E$_{abs}$, which is absorption energy, may be defined by Equation A below.

$$\text{Absorption energy } (E_{abs}) = \sigma^2 \times (1-v)/E \text{ (MPa/m}^2), \qquad \text{(Equation A)}$$

where $\sigma$ is surface strength defined by Equation B below.

$$\text{Surface strength } (\sigma) = (E \times \alpha \times \rho^2)/(1-v) \text{ (MPa/m)}^2, \qquad \text{(Equation B)}$$

where E is Young's modulus, $\alpha$ is a thermal expansion coefficient, $\rho$ is density, and v is Poisson's ratio.

An elastic energy index may be defined as a factor related to the resistance of the glass article 100 to lower bending damage against external impact. The first elastic energy index may have a higher value as the brittleness decreases and the absorption energy increases. In other words, the first elastic energy index of the glass article 100 may have a higher value as the surface strength increases, the brittleness decreases, and the absorption energy increases according to Equations A and B. In an embodiment, the first elastic energy index of the glass article 100 defined by Equation 2-1 above may be $1.0 \times 10^5$ MPa/m$^{1.5}$ or greater.

According to an embodiment, the glass article 100 may further include other factors having high consistency with the pen drop test results in relation to the first elastic energy index. The glass article 100 may have a second elastic energy index defined by Equation 2-2 below and a third elastic energy index defined by Equation 2-3 below.

$$\text{Second elastic energy index } (E_{elas2}) = G_{IC} \times (1/B)^6 \times E_{abs} \text{ (kJ/m}^2)^2 \text{ (Equation 2-2)}.$$

$$\text{Third elastic energy index } (E_{elas3}) = G_{IC} \times (1/B) \times E_{abs} \text{ (MPa}^2/m^{0.5}) \qquad \text{(Equation 2-3)}.$$

In Equations 2-2 and 2-3 above, Gic is a fracture energy index defined by Equation 1. The second elastic energy index and the third elastic energy index of Equations 2-2 and 2-3 may be defined as factors that further include a correlation with the fracture energy index Gic of Equation 1 in the first elastic energy index. Each of the second and third elastic energy indices E$_{elas2}$ and E$_{elas3}$ may further include factors in the first elastic energy index E$_{elas1}$ in consideration of consistency with a pen drop test of the glass article 100. In an embodiment, the second elastic energy index of the glass article 100 defined by Equation 2-2 above may be $5.0 \times 10^{-5}$ (kJ/m$^2$)$^2$ or greater, and the third elastic energy index defined by Equation 2-3 above may be 1.8 MPa$^2$/m$^{0.5}$ or greater.

According to an embodiment, the glass article 100 may have a first free volume index defined by Equation 3-1 below.

$$\text{First free volume index } (V_{t1}) = 1/T_g \text{ (K}^{-1}), \qquad \text{(Equation 3-1)}$$

where T$_g$ is a glass transition temperature. The unit of the first free volume index Vci in Equation 3-1 may be K$^{-1}$.

The glass article 100 may have a free volume index defined as a factor related to the molecular vibration and molecular structure of the glass article 100 upon external impact. The first free volume index $V_{t1}$ is a factor related to the molecular structure of the glass article 100 and may have a lower value as the glass transition temperature increases. When the glass article 100 has a lot of space between molecules due to its molecular structure, that is, when the glass article 100 has a large free volume, the molecular structure can be freely changed against external impact, and breakage resistance against external impact may be excellent. However, this may be in a trade-off relationship with the glass density and bonding strength of the glass article 100. In an embodiment, the first free volume index $V_{t1}$ of the glass article 100 according to Equation 3-1 above may be 0.001 $K^{-1}$ or greater.

According to an embodiment, other factors having high consistency with the pen drop test results in relation to the first free volume index may be further defined for the glass article 100. The glass article 100 may have a second free volume index defined by Equation 3-2 below and a third free volume index defined by Equation 3-3 below.

$$\text{Second free volume index } (V_{t2}) = G_{IC} \times (1/B)^6 \times E_{abs} \times (1/T_g) \ ((kJ/m^2)^2/K), \quad \text{(Equation 3-2)}.$$

$$\text{Third free volume index } (V_{t3}) = G_{IC} \times (1/B) \times E_{abs} \times \sigma \times (1/(T_g)^3) \ (MPa^4/(m^{2.5} \times K^3)),$$

$$\text{(Equation 3-3)}.$$

In Equations 3-2 and 3-3, $T_g$ is a glass transition temperature, Gic is a fracture energy index, B is brittleness, $E_{abs}$ is absorption energy, and $\sigma$ is surface strength. The unit of the second free volume index $V_{t2}$ in Equation 3-2 is $(kJ/m^2)^2/K$, and the unit of the third free volume index $V_{t3}$ in Equation 3-3 is $MPa^4/(m^{2.5} \times K^3)$.

The second free volume index and the third free volume index of Equations 3-2 and 3-3 may be defined as factors that further include correlations with the second elastic energy index and the third elastic energy index of Equations 2-2 and 2-3 in the first free volume index. Each of the second and third free volume indices $V_{t2}$ and $V_{t3}$ may further include factors in the first free volume index Vci in consideration of consistency with a pen drop test of the glass article 100. In an embodiment, the second free volume index $V_{t2}$ of the glass article 100 according to Equation 3-2 may be $5 \times 10^{-8}$ $(kJ/m^2)^2/K$ or greater, and the third free volume index $V_{t3}$ according to Equation 3-3 may be $5 \times 10^{-14}$ $MPa^4/(m^{2.5} \times K^3)$ or greater.

Equations 1, 2-1 through 2-3, and 3-1 through 3-3 described above may be indices associated with the fracture energy, elastic energy, and free volume of the glass article 100. However, the 'fracture energy index', 'elastic energy index', and 'free volume index' of the glass article 100 in the invention may be indices defined by the above equations and may not be equations that exactly match the 'fracture energy', 'elastic energy', and 'free volume' commonly used in the technical field of the invention. The 'fracture energy index', 'elastic energy index', and 'free volume index' defined in the above equations may be defined as equations partially modified in consideration of consistency with pen drop evaluation which is one of the indicators of the impact resistance characteristics of the glass article 100.

The glass article 100 according to an embodiment may have a thickness of 100 $\mu$m or less, for example, a thickness in a range of 20 $\mu$m to 100 $\mu$m, or about 30 $\mu$m, and its fracture energy index, elastic energy index, and free volume index defined by Equations 1, 2-1 through 2-3, and 3-1 through 3-3 may have values in the above-described ranges.

The glass article 100 having a thin thickness and foldability is desired to have a high level of impact resistance. As described above, each of the measurable physical properties of the glass article 100 may not be highly consistent with the pen drop test results and the impact resistance characteristics of the glass article 100. In other words, even if the glass article 100 has a high value in specific physical properties, it may not necessarily have excellent impact resistance characteristics. However, according to an embodiment, the factors defined based on Equations 1, 2-1 through 2-3, and 3-1 through 3-3 to include the measurable physical properties of the glass article 100 may have high consistency with the pen drop test results. Accordingly, the impact resistance characteristics of the glass article 100 can be measured through the quantified factors of the glass article 100.

Hereinafter, the results of a pen drop test performed on various glass articles 100 and the evaluation of consistency between the above-described factors will be described.

Manufacturing Example 1: Manufacture of glass articles

A plurality of glass substrates having various compositions were prepared and divided into SAMPLE #1 through SAMPLE #21. Then, a glass article manufacturing process was performed on each sample according to the above-described method. Each sample was manufactured into a glass article with a thickness of 50 $\mu$m.

Glass article samples were manufactured through the following process.

A glass article was weighed to 500 g for each sample using a PtRh10% crucible, heated to a temperature of 1500 °C to 1650 °C at a rate of 10 K/min, maintained for 3 hours to 6 hours, and then rapidly cooled in a carbon mold at 600 °C to form a glass block.

In order to remove the residual stress of the manufactured glass block, the glass block was annealed for 1 hour to 6 hours at a temperature 30 °C higher than a glass transition temperature identified for each sample, cooled to 400 °C at a rate of 1 K/min, and then cooled to room temperature. Accordingly, a glass block having a thickness of 10 mm was obtained.

For pen drop evaluation of the prepared glass blocks, the glass blocks were cut to a thickness of 270 $\mu$m using a diamond wire saw and then polished on both sides until their thickness became 50 $\mu$m.

A specimen processed to 50 $\mu$m for each sample was chemically tempered using $KNO_3$ molten salt. The surface compressive stress (CS) was in a range of 700 MPa to 800 MPa, and the depth of layer (DoL) was controlled within the range of 15% to 20% of the glass thickness.

In order to compare the factors defined based on the above-described equations with the results of actual pen drop evaluation of the glass articles 100, the flexibility of the structure of the glass article samples was checked through theoretical viscosity calculation, and major impact resistance factors were checked through physical property analysis. First, the viscosity of glass was checked through a Vogel-Fulcher-Tammann (VFT) equation, and an equation (1) related to the viscosity and temperature of glass is as follows.

$$\log \eta = A_{VFT} + \frac{B_{VFT}}{T - T_0} \quad (1)$$

,

where $\eta$ is viscosity, $A_{VFT}$ is high temperature limit viscosity, $T_0$ is a Vogel temperature, and $B_{VFT}$ is viscosity at $T_0$.

In order to check the flexibility of the glass structure based on a Vogel temperature, the following equation (2) was derived based on a Kohlrausch-Williams-Watts (KWW) formula.

$$\beta_{KWW} = 1 - \sqrt{\frac{(T_0 - T_g)^2}{D}} \quad (2)$$

,

where $\beta_{KWW}$ is an elasticity index, D is a strength factor (=$B_{VFT}/T_0$), $T_0$ is a Vogel temperature, and $T_g$ is a glass transition temperature. The Vogel temperature $T_0$ represents an ideal glass transition temperature $T_g$ and refers to a point at which a free volume theoretically desired for relaxation of a glass network structure disappears while the influence of manufacturing conditions such as the cooling rate, capacity, and defects of a glass specimen is generally excluded. Therefore, viscosities at which a glass network structure is formed can be compared by comparing Vogel temperatures. In addition, the elasticity index $\beta_{KWW}$ calculated through $T_0$ represents the mobility and activity of atoms in a glass structure, and the structural flexibility (flow) of the glass network structure can be checked through the elasticity index $\beta_{KWW}$.

Next, physical properties of a glass article for each sample were measured and are shown in Table 1 below along with the Vogel temperature $T_0$ and the elasticity index $\beta_{KWW}$. The measured properties of the glass article were a coefficient of thermal expansion CTE, a glass transition temperature $T_g$, density $\rho$, Young's modulus E, Poisson's ratio v, hardness $H_v$, fracture toughness Kic, and brittleness B.

Here, the glass transition temperature $T_g$ was checked using differential thermal analysis (DTA) equipment by preparing 5 g of each glass sample and raising the temperature at a rate of 10 K/min to the glass transition temperature range. The thermal expansion coefficient of glass was checked using a thermo-mechanical analyzer (TMA) by preparing a specimen with a size of $10 \times 10 \times 13$ mm$^3$ for each composition and raising the temperature at a rate of 10 K/min to the glass transition temperature range.

The Poisson's ratio was checked using an elastic modulus tester by preparing a specimen with a size of $10 \times 20 \times 3$ mm$^3$ for each composition and checking the stress and strain of the specimen.

The hardness $H_v$ and the fracture toughness Kic were calculated using Equations 3 and 4 below by applying a load of 4.9 N for 30 seconds with a Vickers hardness tester using a 19 $\mu$m size diamond tip.

$$H_V = 1.854 \cdot \frac{F}{a^2} \qquad (3)$$

where Hv is Vickers hardness, F is a load, and $\alpha$ is an indentation length.

$$\frac{K_{IC} \cdot \phi}{H_V \cdot a^{\frac{1}{2}}} = 0.15 \cdot K \cdot \left(\frac{c}{a}\right)^{-\frac{3}{2}} \qquad (4)$$

where Kic is fracture toughness, $\phi$ is a constraint index ($\phi \approx 3$), $H_V$ is Vickers hardness, K is a constant (=3.2), c is a crack length, and $\alpha$ is an indentation length.

The brittleness B was calculated using Equation 5 below by applying a load of 4.9 N for 30 seconds using a Vickers hardness tester.

$$B = \gamma \, P^{-1/4} \frac{C^{3/2}}{a} \qquad (5)$$

where B is brittleness, $\gamma$ is a constant (2.39 $N^{1/4}/\mu m^{1/2}$), P is an indentation load, $\alpha$ is an indentation length, and C is a crack length.

The crack generation load was measured using a Vickers hardness tester.

[Table 1]

| Sample group | CTE | $T_g$ | $\rho$ | E | v | $H_v$ | $K_{IC}$ | B |
|---|---|---|---|---|---|---|---|---|
| Unit | $10^{-7}$/K | K | g/cm$^3$ | MPa | - | MPa | MPa$\times$m$^{0.5}$ | $\mu$m$^{-0.5}$ |
| SAMPLE#1 | 84 | 859.1 | 2.464 | 85000 | 0.213 | 6678.3 | 1.27 | 5.26 |
| SAMPLE#2 | 84 | 862.1 | 2.458 | 80000 | 0.202 | 6697.9 | 1.38 | 4.85 |
| SAMPLE#3 | 74 | 888.1 | 2.446 | 79000 | 0.202 | 6531.2 | 1.29 | 5.06 |
| SAMPLE#4 | 73.2 | 816.1 | 2.443 | 105000 | 0.348 | 5854.6 | 1.09 | 5.37 |
| SAMPLE#5 | 80 | 963.1 | 2.442 | 80000 | 0.202 | 6786.2 | 1.28 | 5.3 |
| SAMPLE#6 | 90 | 938.1 | 2.466 | 65000 | 0.242 | 5148.5 | 0.901 | 5.71 |
| SAMPLE#7 | 91 | 791.1 | 2.48 | 73000 | 0.23 | 5285.8 | 0.78 | 6.78 |
| SAMPLE#8 | 91.2 | 827.1 | 2.434 | 66000 | 0.197 | 4785.6 | 0.896 | 5.34 |
| SAMPLE#9 | 85.9 | 859.1 | 2.555 | 67000 | 0.242 | 5295.6 | 0.781 | 6.78 |
| SAMPLE#10 | 89 | 880.1 | 2.46 | 72000 | 0.22 | 5393.7 | 0.87 | 6.2 |
| SAMPLE#11 | 85.6 | 838.1 | 2.503 | 63000 | 0.237 | 5060.2 | 0.787 | 6.43 |
| SAMPLE#12 | 79.9 | 860.1 | 2.5 | 74000 | 0.13 | 5266.2 | 0.815 | 6.46 |
| SAMPLE#13 | 76 | 1003.1 | 2.444 | 78000 | 0.219 | 6501.8 | 1.29 | 5.04 |
| SAMPLE#14 | 77.1 | 959.1 | 2.63 | 64000 | 0.277 | 4658.2 | 0.914 | 5.1 |
| SAMPLE#15 | 82 | 860.1 | 2.473 | 82000 | 0.202 | 7011.8 | 1.02 | 6.87 |
| SAMPLE#16 | 84 | 1054.1 | 2.454 | 71000 | 0.197 | 5079.8 | 0.873 | 5.82 |
| SAMPLE#17 | 45 | 1040.1 | 2.555 | 86000 | 0.254 | 6492 | 1.082 | 6 |

(continued)

| Sample group | CTE | $T_g$ | $\rho$ | E | v | $H_v$ | $K_{IC}$ | B |
|---|---|---|---|---|---|---|---|---|
| SAMPLE#18 | 35.2 | 1045.1 | 2.56 | 85000 | 0.243 | 7100 | 0.919 | 7.73 |
| SAMPLE#19 | 30.4 | 1028.1 | 2.512 | 92000 | 0.254 | 7433.4 | 1.067 | 6.97 |
| SAMPLE#20 | 85 | 932.1 | 2.428 | 66000 | 0.242 | 5060.2 | 0.772 | 6.55 |
| SAMPLE#21 | 61.9 | 952.1 | 2.458 | 72000 | 0.228 | 6648.9 | 0.928 | 7.16 |

(CTE is a coefficient of thermal expansion, $T_g$ is a glass transition temperature, $\rho$ is density, E is Young's modulus, v is Poisson's ratio, $H_v$ is hardness, Kic is fracture toughness, and B is brittleness)

Experimental Example 1: Impact resistance evaluation - pen drop evaluation (pen diameter: 0.7 mm)

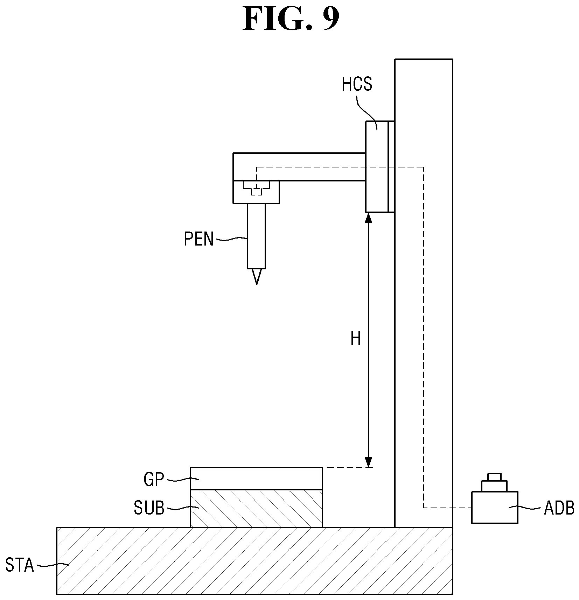

A pen drop test was performed as shown in FIG. 9 using the glass article samples manufactured in Manufacturing Example 1 above.

FIG. 9 is a diagram illustrating a method of performing a pen drop test on a glass article according to an embodiment.

Referring to FIG. 9, a glass article sample GP having a thickness of 50 $\mu$m was bonded to a polyethylene film substrate SUB having a thickness of 250 $\mu$m. After the glass article sample GP and the substrate SUB were bonded together and cured for greater than 30 minutes, a pen drop test was performed. The pen drop test was performed using a pen having a ball diameter of 0.7 mm and a weight of 1.12 g at a temperature in a range of 20 °Cto 22 °C and a humidity of 30%. The pen was dropped using an automatic drop device ADB until the glass article sample GP broke. A drop height H was increased by 0.5 cm using a drop height control device HCS. After one drop, the glass article sample GP was observed under a microscope to check cracks or breakage. The drop height H was defined as a vertical distance from the glass article sample GP to the drop height control device HCS.

This pen drop test was performed 30 times on three or greater sheets of the same glass article sample GP, and average values were measured and are shown in Table 2 below. In addition, the physical properties measured in Manufacturing Example 1 and the fracture energy index, elastic energy index and free volume index defined in Equations 1, 2-1 through 2-3, and 3-1 through 3-3 described above were calculated and are shown in Table 2 below.

[Table 2]

| Sample group | PDT (H) | Equation 1 ($G_{IC}$) | Equation 2-1 ($E_{elas1}$) | Equation 2-2 ($E_{elas2}$) | Equation 2-3 ($E_{elas3}$) | Equation 3-1 ($V_{t1}$) | Equation 3-2 ($V_{t2}$) | Equation 3-3 ($V_{t3}$) |
|---|---|---|---|---|---|---|---|---|
| Unit | (cm) | $kJ/m^2$ | $MPa/m^{1.5}$ ($\times 10^5$) | $(kJ/m^2)^2$ ($10^{-5}$) | $MPa/m^{0.5}$ | /K | $(kJ/m^2)^2/K$ ($10^{-7}$) | $MPa^4/m^{2.5}K^3$ ($10^{-14}$) |
| SAMPLE#1 | 6.68 | 181.1 | 1.31 | 5.8 | 2.365 | 0.0012 | 0.68 | 8.4 |
| SAMPLE#2 | 6.57 | 228.3 | 1.11 | 9.4 | 2.533 | 0.0012 | 1.1 | 9.6 |
| SAMPLE#3 | 5.98 | 202.1 | 0.59 | 3.6 | 1.199 | 0.00113 | 0.41 | 5 |
| SAMPLE#4 | 5.92 | 99.4 | 2.28 | 5.08 | 2.27 | 0.00123 | 0.62 | 7 |
| SAMPLE#5 | 3.98 | 196.4 | 0.79 | 3.72 | 1.558 | 0.00104 | 0.39 | 5 |
| SAMPLE#6 | 3.96 | 117.6 | 0.8 | 1.53 | 0.938 | 0.00107 | 0.16 | 3 |
| SAMPLE#7 | 3.23 | 78.9 | 0.99 | 0.55 | 0.785 | 0.00126 | 0.07 | 4 |
| SAMPLE#8 | 3.15 | 116.9 | 0.71 | 1.91 | 0.835 | 0.00121 | 0.23 | 4 |
| SAMPLE#9 | 2.63 | 85.7 | 0.81 | 0.49 | 0.695 | 0.00116 | 0.06 | 3 |
| SAMPLE#10 | 2.5 | 100 | 0.86 | 0.93 | 0.86 | 0.00114 | 0.11 | 3 |
| SAMPLE#11 | 2.5 | 92.8 | 0.58 | 0.49 | 0.541 | 0.00119 | 0.06 | 3 |
| SAMPLE#12 | 2.17 | 88.2 | 0.48 | 0.37 | 0.421 | 0.00116 | 0.04 | 2 |

(continued)

| Sample group | PDT (H) | Equation 1 ($G_{IC}$) | Equation 2-1 ($E_{elas1}$) | Equation 2-2 ($E_{elas2}$) | Equation 2-3 ($E_{elas3}$) | Equation 3-1 ($V_{t1}$) | Equation 3-2 ($V_{t2}$) | Equation 3-3 ($V_{t3}$) |
|---|---|---|---|---|---|---|---|---|
| SAMPLE#13 | 2.16 | 203.1 | 0.68 | 4.22 | 1.374 | 0.001 | 0.42 | 4 |
| SAMPLE#14 | 2.02 | 120.5 | 0.09 | 3.1 | 1.069 | 0.00104 | 0.32 | 3 |
| SAMPLE#15 | 2.02 | 121.7 | 0.8 | 0.63 | 0.979 | 0.00116 | 0.074 | 4 |
| SAMPLE#16 | 2 | 103.2 | 0.62 | 0.97 | 0.647 | 0.00095 | 0.09 | 2 |
| SAMPLE#17 | 1.91 | 127.3 | 0.15 | 0.25 | 0.195 | 0.00096 | 0.02 | 1 |
| SAMPLE#18 | 1.5 | 93.5 | 0.04 | 0.01 | 0.039 | 0.00096 | 0.001 | 0.9 |
| SAMPLE#19 | 1.5 | 115.8 | 0.03 | 0.02 | 0.034 | 0.00097 | 0.002 | 0.9 |
| SAMPLE#20 | 1.2 | 85 | 0.51 | 0.36 | 0.435 | 0.00107 | 0.04 | 2 |
| SAMPLE#21 | 0.83 | 113.4 | 0.18 | 0.11 | 0.202 | 0.00105 | 0.01 | 1 |

In Table 2, the glass article samples are arranged in order of excellent pen drop test results. In the pen drop test, SAMPLE#1 showed excellent impact resistance characteristics by cracking at the highest position, and SAMPLE #21 showed poor impact resistance characteristics by cracking at the lowest position.

Referring to Table 2, it can be seen that the results of the pen drop test and the values of Equations 1, 2-1 through 2-3, and 3-1 through 3-3 show substantially the same tendency. It can be seen that samples having small values of Equations 1, 2-1 through 2-3, and 3-1 through 3-3 generally show low pen drop test results. That is, it can be predicted that small values of the fracture energy index, the elastic energy index, and the free volume index described above will lead to low impact resistance characteristics. Conversely, it can be seen that samples having large values of Equations 1, 2-1 through 2-3, and 3-1 through 3-3 show improved pen drop test results. That is, it can be predicted that large values of the fracture energy index, the elastic energy index, and the free volume index described above will lead to high impact resistance characteristics.

A glass article according to an embodiment may have high impact resistance characteristics because its fracture energy index, elastic energy index, and free volume index have values equal to or greater than a certain value. A display device including the glass product may have high flexibility and strength because the glass article has foldable characteristics.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

**Claims**

1. A glass article (100-103) having a thickness in a range of 20 $\mu$m to 100 $\mu$m and a third elastic energy index of 1.8 $MPa^2/m^{0.5}$ or greater,

   wherein the third elastic energy index is defined by Equation 2-3 below:

   $$\text{Third elastic energy index } (E_{elas3}) = G_{IC} \times (1/B) \times E_{abs} \qquad \text{(Equation 2-3),}$$

   where Gic is a fracture energy index defined by Equation 1 below:

   $$\text{Fracture energy index } (G_{IC}) = (K_{IC}^2 \times (1-v^2))/E \qquad \text{(Equation 1),}$$

where Kic is fracture toughness, v is Poisson's ratio, and E is Young's modulus,
B is brittleness (fracture toughness Kic/hardness $H_v$), and $E_{abs}$ is absorption energy defined by Equation A below:

$$\text{Absorption energy } (E_{abs}) = \sigma^2 \times (1\text{-v})/E \qquad \text{(Equation A),}$$

where $\sigma$ is surface strength defined by Equation B below:

$$\text{Surface strength } (\sigma) = (E \times \alpha \times \rho^2)/(1\text{-v}) \qquad \text{(Equation B),}$$

where E is Young's modulus, $\alpha$ is a thermal expansion coefficient, $\rho$ is density, and v is Poisson's ratio.

2. The glass article (100-103) of claim 1, having a second elastic energy index of $5.0 \times 10^{-5}$ $(kJ/m^2)^2$ or greater, wherein the second elastic energy index is defined by Equation 2-2 below:

$$\text{Second elastic energy index } (E_{elas2}) = G_{IC} \times (1/B)^6 \times E_{abs} \qquad \text{(Equation 2-2),}$$

where Gic is the fracture energy index defined by Equation 1 above, and B and $E_{abs}$ are as defined in Equation 2-3 above.

3. A glass article (100-103) having a thickness in a range of 20 $\mu$m to 100 $\mu$m and a third free volume index of $5 \times 10^{-14}$ $MPa^4/(m^{2.4} \times K^3)$ or greater,

wherein the third free volume index is defined by Equation 3-3 below:

$$\text{Third free volume index } (V_{t3}) = G_{IC} \times (1/B) \times E_{abs} \times \sigma \times (1/(T_g)^3) \qquad \text{(Equation 3-3),}$$

where $T_g$ is a glass transition temperature, and Gic is a fracture energy index defined by Equation 1 below:

$$\text{Fracture energy index } (G_{IC}) = (K_{IC}^2 \times (1\text{-v}^2))/E \qquad \text{(Equation 1),}$$

where Kic is fracture toughness, v is Poisson's ratio, and E is Young's modulus,
B is brittleness (fracture toughness Kic/hardness $H_v$), and $E_{abs}$ is absorption energy defined by Equation A below:

$$\text{Absorption energy } (E_{abs}) = \sigma^2 \times (1\text{-v})/E \qquad \text{(Equation A),}$$

wherein in Equations 3-3 and A, $\sigma$ is surface strength defined by Equation B below:

$$\text{Surface strength } (\sigma) = (E \times \alpha \times \rho^2)/(1\text{-v}) \qquad \text{(Equation B),}$$

where E is Young's modulus, $\alpha$ is a thermal expansion coefficient, $\rho$ is density, and v is Poisson's ratio.

4. The glass article (100-103) of claim 3, having a first free volume index of 0.001 $K^{-1}$ or greater, wherein the first free volume index is defined by Equation 3-1 below:

$$\text{First free volume index } (V_{t1}) = 1/T_g \qquad \text{(Equation 3-1),}$$

where '$T_g$' is a glass transition temperature.

5. The glass article (100-103) of claim 4, having a second free volume index of $5 \times 10^{-8}$ $(kJ/m^2)^2/K$ or greater, wherein the second free volume index is defined by Equation 3-2:

$$\text{Second free volume index } (V_{t2}) = G_{IC} \times (1/B)^6 \times E_{abs} \times (1/T_g) \quad \text{(Equation 3-2)},$$

where $T_g$ is a glass transition temperature, Gic is the fracture energy index defined by Equation 1 above, B is the brittleness, $E_{abs}$ is the absorption energy, and $\sigma$ is the surface strength.

6. A glass article (100-103) having a thickness in a range of 20 $\mu$m to 100 $\mu$m and a second elastic energy index of $5.0 \times 10^{-5}$ $(kJ/m^2)^2$ or greater,

   wherein the second elastic energy index is defined by Equation 2-2 below:

$$\text{Second elastic energy index } (E_{elas2}) = G_{IC} \times (1/B)^6 \times E_{abs} \quad \text{(Equation 2-2)}$$

   where Gic is a fracture energy index defined by Equation 1 below:

$$\text{Fracture energy index } (G_{IC}) = (K_{IC}^2 \times (1-v^2))/E \quad \text{(Equation 1)},$$

   where Kic is fracture toughness, v is Poisson's ratio, and E is Young's modulus,
   B is brittleness (fracture toughness Kic/hardness $H_v$), and $E_{abs}$ is absorption energy defined by Equation A below:

$$\text{Absorption energy } (E_{abs}) = \sigma^2 \times (1-v)/E \quad \text{(Equation A)},$$

   where $\sigma$ is surface strength defined by Equation B below:

$$\text{Surface strength } (\sigma) = (E \times \alpha \times \rho^2)/(1-v) \quad \text{(Equation B)},$$

   where E is Young's modulus, $\alpha$ is a thermal expansion coefficient, $\rho$ is density, and v is Poisson's ratio.

7. The glass article (100-103) of claim 1, 2 or 6, having a first elastic energy index of $1.0 \times 10^5$ $MPa/m^{1.5}$ or greater, wherein the first elastic energy index is defined by Equation 2-1 below:

$$\text{First elastic energy index } (E_{elas1}) = (1/B) \times E_{abs} \quad \text{(Equation 2-1)},$$

   where B and $E_{abs}$ are as defined in Equation 2-2 of claim 6 or Equation 2-3 of claim 1.

8. The glass article (100-103) of claim 6 or 7, having a third elastic energy index of 1.8 $MPa^2/m^{0.5}$ or greater, wherein the third elastic energy index is defined by Equation 2-3 below:

$$\text{Third elastic energy index } (E_{elas3}) = G_{IC} \times (1/B) \times E_{abs} \quad \text{(Equation 2-3)},$$

   where Gic is the fracture energy index defined by Equation 1 above, and B and $E_{abs}$ are as defined in Equation 2-2 above.

9. A glass article (100-103) having a thickness in a range of 20 $\mu$m to 100 $\mu$m and a second free volume index of $5 \times 10^{-8}$ $(kJ/m^2)^2/K$ or greater,

   wherein the second free volume index is defined by Equation 3-2 below:

$$\text{Second free volume index } (V_{t2}) = G_{IC} \times (1/B)^6 \times E_{abs} \times (1/T_g) \quad \text{(Equation 3-2)},$$

   where $T_g$ is a glass transition temperature, and Gic is a fracture energy index defined by Equation 1 below:

$$\text{Fracture energy index } (G_{IC}) = (K_{IC}^2 \times (1-v^2))/E \qquad \text{(Equation 1)}$$

where Kic is fracture toughness, v is Poisson's ratio, and E is Young's modulus, B is brittleness (fracture toughness Kic/hardness $H_v$), and $E_{abs}$ is absorption energy defined by Equation A below:

$$\text{Absorption energy } (E_{abs}) = \sigma^2 \times (1-v)/E \qquad \text{(Equation A)},$$

where $\sigma$ is surface strength defined by Equation B below:

$$\text{Surface strength } (\sigma) = (E \times \alpha \times \rho^2)/(1-v) \qquad \text{(Equation B)},$$

where E is Young's modulus, $\alpha$ is a thermal expansion coefficient, $\rho$ is density, and v is Poisson's ratio.

10. The glass article (100-103) of at least one of claims 1 to 9, having a cracking height of 6 cm or greater in a pen drop test performed using a pen with a ball diameter of 0.7 mm and a weight of 1.12 g.

11. The glass article (100-103) of at least one of claims 1 to 10, wherein the fracture energy index is 150 kJ/m$^2$ or greater.

12. The glass article (100-103) of at least one of claims 9 to 11, having a first free volume index of 0.001 K$^{-1}$ or greater, wherein a first free volume index is defined by Equation 3-1 below:

$$\text{First free volume index } (V_{t1}) = 1/T_g \qquad \text{(Equation 3-1)},$$

where $T_g$ is a glass transition temperature.

13. The glass article (100-103) of claim 12, having a third free volume index of $5 \times 10^{-14}$ MPa$^4$/(m$^{2.5} \times$K$^3$) or greater, wherein the third free volume index is defined by Equation 3-3 below:

$$\text{Third free volume index } (V_{t3}) = G_{IC} \times (1/B) \times E_{abs} \times \sigma \times (1/(T_g)^3) \qquad \text{(Equation 3-3)},$$

where $T_g$ is a glass transition temperature, and Gic is the fracture energy index defined by Equation 1 above, B is the brittleness, $E_{abs}$ is the absorption energy, and $\sigma$ is the surface strength.

14. A display device (500) comprising:

a display panel (200) comprising a plurality of pixels (PX);
a cover window disposed on the display panel (200); and
an optically clear bonding layer (300) disposed between the display panel (200) and the cover window,
wherein the cover window comprises a glass article (100-103) according to claim 1 or 2 and according to claim 11 having a third elastic energy index of 1.8 MPa$^2$/m$^{0.5}$ or greater.

15. A display device (500) comprising:

a display panel (200) comprising a plurality of pixels (PX);
a cover window disposed on the display panel (200); and
an optically clear bonding layer (300) disposed between the display panel (200) and the cover window,

wherein the cover window comprises a glass article (100-103) according to at least one of claims 3 to 10, 12 to 13 and according to claim 11.

16. Use of a glass article (100-103) according to at least one of claims 1 to 13, a cover window disposed on a display panel (200) of the foldable display device (500).

# FIG. 1

US

103

RS SS

US

102

RS SS

US

101

RS SS

US

100

SS

RS

# FIG. 2

500

NFA1

FDA

NFA2

NDA

DA

DR3

DR2

DR1

# FIG. 3

# FIG. 4

500

100
300
200

# FIG. 5

# FIG. 6

# FIG. 7

```
        ┌──────────────┐
        │    START     │
        └──────┬───────┘
               ▼
┌──────────────────────────────────┐  S1
│          FORMING STEP            │
└──────────────┬───────────────────┘
               ▼
┌──────────────────────────────────┐  S2
│          CUTTING STEP            │
└──────────────┬───────────────────┘
               ▼
┌──────────────────────────────────┐  S3
│     SIDE SURFACE POLISHING STEP  │
└──────────────┬───────────────────┘
               ▼
┌──────────────────────────────────┐  S4
│ SURFACE POLISHING STEP BEFORE STRENGTHENING │
└──────────────┬───────────────────┘
               ▼
┌──────────────────────────────────┐  S5
│      STRENGTHENING STEP          │
└──────────────┬───────────────────┘
               ▼
┌──────────────────────────────────┐  S6
│ SURFACE POLISHING STEP AFTER STRENGTHENING │
└──────────────┬───────────────────┘
               ▼
        ┌──────────────┐
        │     END      │
        └──────────────┘
```

# FIG. 8

# FIG. 9

Europäisches
Patentamt

European
Patent Office

Office européen
des brevets

# EUROPEAN SEARCH REPORT

Application Number

EP 23 21 6263

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 101 620 375 B1 (GF CO LTD [KR]; SONG YOUNG NAM [KR]) 23 May 2016 (2016-05-23) * paragraphs [0001] - [0004], [0036], [0111]; claims * ----- | 1-16 | INV. C03C21/00 B24B1/00 |
| X | KR 102 263 657 B1 (DONGWOO FINE CHEM CO LTD [KR]) 10 June 2021 (2021-06-10) * paragraphs [0001] - [0003]; claims; examples 1-7 * ----- | 1-16 | |
| A | EP 3 838 860 A1 (SAMSUNG DISPLAY CO LTD [KR]) 23 June 2021 (2021-06-23) * claims; figures 1-7 * ----- | 1-16 | |

**TECHNICAL FIELDS SEARCHED    (IPC)**

C03C
B24D
B24B

The present search report has been drawn up for all claims

| Place of search | Date of completion of the search | Examiner |
|---|---|---|
| Munich | 15 April 2024 | Zandonà, Alessio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 6263

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2024

| Patent document cited in search report | | Publication date | Patent family member(s) | | Publication date |
|---|---|---|---|---|---|
| KR 101620375 | B1 | 23-05-2016 | NONE | | |
| KR 102263657 | B1 | 10-06-2021 | CN | 115667170 A | 31-01-2023 |
| | | | KR | 102263657 B1 | 10-06-2021 |
| | | | US | 2023202914 A1 | 29-06-2023 |
| | | | WO | 2021235741 A1 | 25-11-2021 |
| EP 3838860 | A1 | 23-06-2021 | CN | 113003945 A | 22-06-2021 |
| | | | EP | 3838860 A1 | 23-06-2021 |
| | | | KR | 20210080654 A | 01-07-2021 |
| | | | US | 2021188695 A1 | 24-06-2021 |

EPO FORM P0459

For more details about this annex : see Official Journal of the European Patent Office, No. 12/82